# EUROPEAN PATENT APPLICATION

(11) **EP 0 661 778 A2**
(43) Date of publication of application: **05.07.1995**
(21) Application number: 94116715.7
(22) Date of filing: 22.10.1994
(51) Int. Cl.: H01R 23/68, H01R 9/07, H05K 3/36

(54) **Method and apparatus for providing electrical power to electronic devices enclosed in a chip carrier**

(30) Priority: 28.12.1993 US 174560
(71) Applicant: International Business Machines Corporation, Armonk, N.Y. 10504 (US)
(72) Inventor: Foster, Richard A., Round Rock, Texas 78681 (US)
(74) Representative: Burt, Roger James, Dr.

(57) **Abstract**

A laminar power bus (26) is provided. The laminar power bus includes a plurality of interfacing sheets (32, 34, 36, 52, 54). Power is transferred from a power supply to a chip carrier via a first and second conductive sheets (34, 36) adhered to opposite sides of an insulating sheet (32). Apertures (48) through the second conductive sheet (36), and a concentrically aligned apertures (46) through the insulating sheet (32) permits depressions forming protrusions (38) in the first conductive sheet (34) to protrude through the second conductive sheet (36) and extend beyond the plane of the first conductive sheet (34). Additional depressions in the second conductive sheet (36) forming protrusions (42) extending away from the insulating sheet (52). The protrusions (38, 42) in the first and second conductive sheets (34, 36) are arranged in a pattern corresponding to a pattern of metal pads (40, 44) for receiving electrical power on the substrate (22) of the chip carrier. The laminar power bus is connected to the substrate (22) of the chip carrier.

## Description

The present invention relates in general to an improved method and apparatus for distributing electrical power to electronic devices within a data processing system, and in particular to a method and apparatus for providing electrical power to an electronic device enclosed in a chip carrier.

As the number of transistors within an integrated circuit device increases, and as the switching speed of such transistors increases, several problems may arise. One such problem is that of connecting such an integrated circuit to signals from other circuits in the data processing system, and to a power supply.

Typically, such integrated circuits have many power pins and signal connection pins. In order to keep the integrated circuit package size manageable, power and signal pins may be arranged in a pin grid array. Such a pin grid array may be comprised of pins, which may be spaced 1,2699 mm. apart (fifty thousandths of an inch, i.e. 50 mils.), arranged in a rectangular grid pattern on one surface of the integrated circuit package. In the prior art, a high density area array connector may be utilized to connect power and other electrical signals to such a pin grid array package.

There are many problems, however, with utilizing a high density area array connector to connect power and signals to a pin grid array package. The first problem is reliability. Typically, socket connections are designed to permit easy removal of the electronic device. Such a removable connection may be unreliable due to dirt build up in the connector socket, oxidation of socket and pin surfaces, and a weakening of the mechanical grasp of the pins.

A second problem is size. High density area array connectors are bulkier, which results in a higher overall package profile of the integrated circuit. Frequently, reduction of the overall packaging volume is an important design goal. If the profile, or height, of the integrated circuits may be reduced, the goal of reducing package volume may be more easily accomplished. For example, some high performance package assembly configurations have a minimum component height as a design goal. In such assemblies, utilizing a high density area array connector makes this design goal more difficult to achieve.

A third problem with high density area array connectors is cost. Many high density area array connectors known in the prior art include pin sockets which are produced utilizing expensive manufacturing processes. Moreover, such pin sockets may be plated with gold to increase conductivity and reduce oxidation. Such gold plating further increases the cost of high density area array connectors.

Finally, high density area array connectors may add series inductance to the power supply circuit which supplies power to the integrated circuit. This inductance may cause voltage drops during high current transients. As the speed of digital computation increases, and as the number of transistors increases within an integrated circuit, the peak or instantaneous current demand of the integrated circuit may also increase. During periods of high current transients, the inductance added by the high density area array connector may significantly reduce the voltage applied to power pins on the integrated circuit. Power supply voltage drops are a problem because they may cause errors in digital information stored and transferred within the integrated circuit. Moreover, the use of lower voltage devices to provide high speed switching with lower power dissipation places tighter tolerances on the voltage fluctuations which are allowed at the power connections of the integrated circuit package. Therefore, reducing series inductance is an important design goal.

Therefore, the problems remaining in the prior art are to provide a method and apparatus for distributing electrical power to electronic devices enclosed in a chip carrier assembly which has a low series inductance in the conductive path, which is inexpensive to manufacture, highly reliable, easy to assemble, and has a low profile. Such problems are solved by the present invention as claimed.

It is another object of the present invention to provide a method and apparatus for distributing electrical power to electronic devices within a data processing system.

It is another object of the present invention to provide a method and apparatus for providing electrical power to an electronic device enclosed in a chip carrier.

A laminar power bus for providing electrical power to an electronic device enclosed in a chip carrier is provided. The laminar power bus includes a plurality of interfacing sheets. Power is transferred from a power supply to a chip carrier via two conductive sheets adhered to opposite sides of an insulating sheet. An aperture through a first conductive sheet, and a concentrically aligned aperture through the insulating sheet permits a depression, which forms a protrusion in the second conductive sheet, to protrude through the first conductive sheet and extend beyond the plane of the first conductive sheet. Additional depressions in the first conductive sheet, which form protrusions extending away from the insulating sheet, extend to the plane defined by the protrusions on the second conductive sheet. The protrusions in the first and second conductive sheets are arranged in a pattern corresponding to a pattern of metal pads for receiving electrical power on the substrate of a chip carrier. The laminar power bus may be mechanically and electrically connected to the substrate of a chip carrier by soldering the protrusions to the metal pads on the chip carrier substrate. The laminar power bus is also adapted for connection to the data processing system power supply. The two conductive sheets of the laminar power bus provide a highly conductive current path having low series inductance.

The above as well as additional objects, features, and advantages of the present invention will become apparent in the following detailed written description.

The invention itself however, as well as a preferred mode of use, further objects and advantages thereof, will best be understood by reference to the following detailed description of an illustrative embodiment when read in conjunction with the accompanying drawings, wherein:
**Figure 1** depicts a fragmentary section view of a data processing system which utilizes a laminar power bus in accordance with the method and system of the present invention;
**Figure 2** depicts an exploded view of a laminar power bus in accordance with the method and system of the present invention; and
**Figure 3** is a partial section view of a laminar power bus soldered to the substrate of a chip carrier in accordance with the method and system of the present invention.

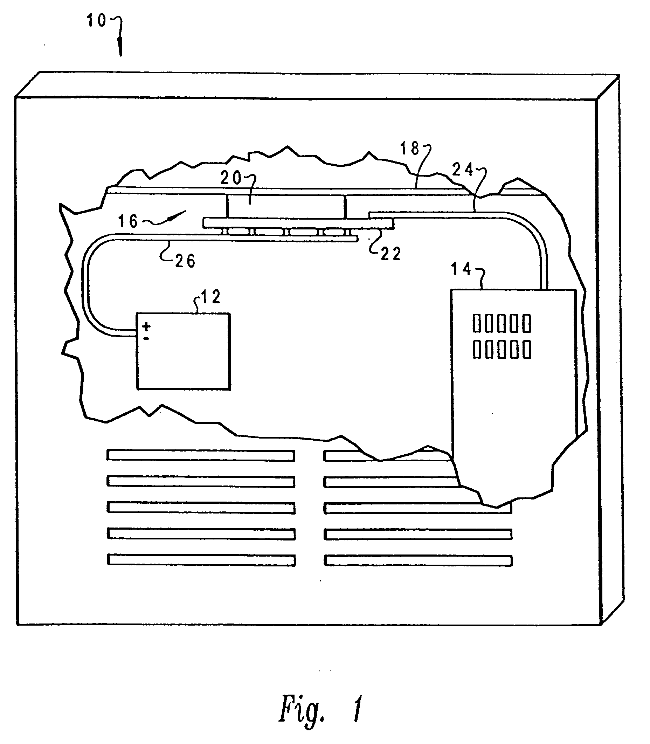

With reference now to the figures and in particular with reference to **Figure 1**, there is depicted a fragmentary section view of a data processing system which utilizes a laminar power bus in accordance with the method and apparatus of the present invention. Those persons having ordinary skill in the art should recognize that **Figure 1** has not been drawn to scale; however, it is utilized to illustrate the environment and method of utilizing the present invention. As illustrated, data processing system **10** includes power supply **12** and printed circuit board **14**. Printed circuit board **14** preferably includes memory, or other integrated or discrete electronic components. Chip carrier **16** is shown mounted to support structure **18**. Support structure **18** is typically designed to conduct heat away from chip carrier **16**. Chip carrier **16** includes cover **20** and substrate **22** Cover **20** is preferably mounted to support structure **18** by any one of several known means, such as threaded fasteners or clamps.

Signal connections between chip carrier **16** and printed circuit board **14** are typically made utilizing flex circuit **24**. In accordance with the present invention, power is supplied to chip carrier **16** by power supply **12** via laminar power bus **26**. Laminar power bus **26** is preferably connected to substrate **22** of chip carrier **16** by applying solder paste to substrate **22** and reflow soldering laminar power bus **26** to substrate **22**, as discussed in more detail below.

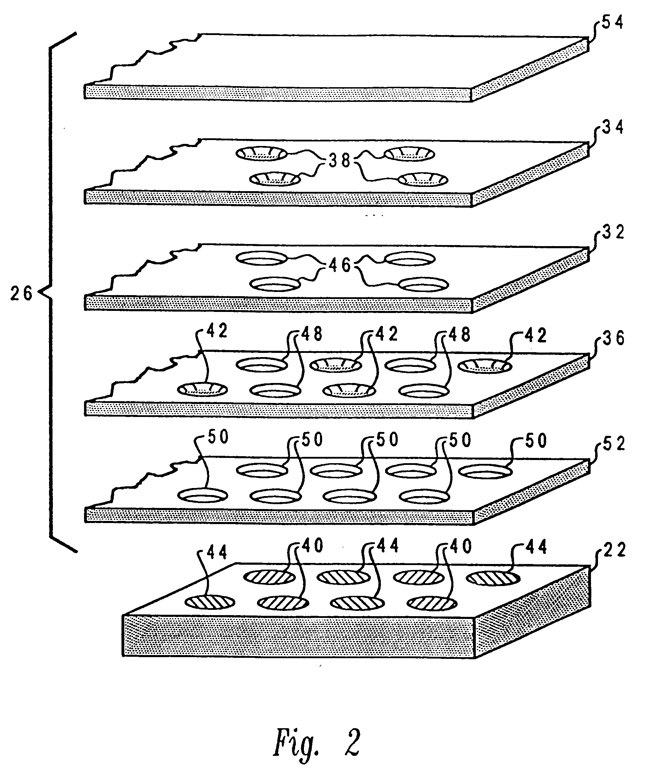

With reference now to **Figure 2** there is depicted an exploded view of laminar power bus **26** in accordance with the method and apparatus of the present invention. Those persons having ordinary skill in the art should recognize that **Figure 2** is not drawn to scale; however, it is utilized to illustrate the structure of laminar power bus **26** and the correspondence of features of laminar power bus **26** with substrate **22** of chip carrier **16**.

As illustrated, laminar power bus **26** is comprised of a plurality of interfacing sheets, each of which is substantially uniform in thickness. Such interfacing sheets are classified as either an insulating sheet or a conducting sheet. Insulating sheet **32** is located at the center of laminar power bus **26**. Conducting sheet **34** and conducting sheet **36** are adhered to opposite sides of insulating sheet **32.** In a preferred embodiment of the present invention, the insulating sheets of laminar power bus **26** are fabricated from epoxy glass laminate or polyimide film. Conducting sheets **34** and **36** are preferably fabricated from oxygen free high conductivity copper.

Within conducting sheet **34**, a plurality of dimples, or depressions, **38** are located in a pattern corresponding to a pattern of metal pads **40** on the surface of substrate **22.** Such metal pads **40** are provided for electrically connecting the integrated circuit inside chip carrier **16** to a positive terminal of power supply **12** (see **Figure 1**). In a similar manner, dimples **42** are located within conducting sheet **36** in a pattern corresponding to metal pads **44** on the surface of substrate **22.** Metal pads **44** are provided for electrically connecting the integrated circuit inside chip carrier **16** to a negative terminal on power supply **12.**

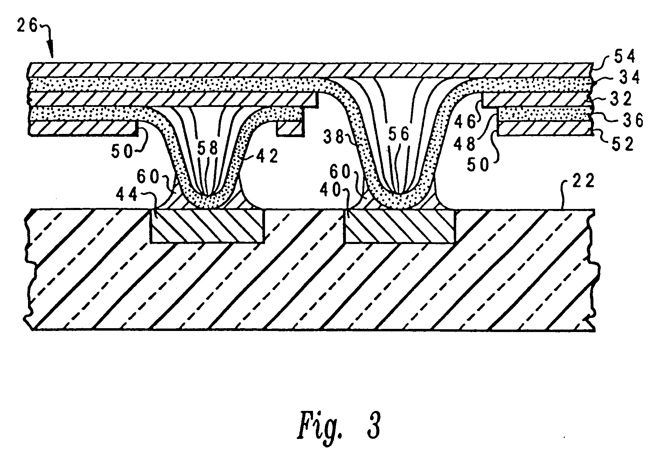

Dimples **38** and **42** are preferably formed by a stamping process which deforms the surface of conducting sheets **34** and **36**. Such deformation defines a plurality of protrusions which are not shown in detail in **Figure 2**, but are shown more clearly in the section view of **Figure 3**. When the sheets comprising laminar power bus **26** are assembled, such protrusions formed by dimples **38** extend through apertures **46** in insulating sheet **32**, and apertures **48** in conducting sheet **36**, and apertures **50** in insulating sheet **52**. The tips of protrusions in conducting sheet **34** formed by dimples **38** are substantially co-planar, and are located so that they may be soldered to metal pads **40** on the surface of substrate **22**. Similarly, the tips of protrusions formed by dimples **42** in conducting sheet **36** are substantially co-planar with the protrusions in conducting sheet **34**, and are located so that they are soldered to metal pads **44** on the surface of substrate **22**.

Insulating sheet **54** is preferably adhered to conducting sheet **34** to prevent conducting sheet **34** from shorting to another electrical component, or a portion of the chassis or other conductor within data processing system **10**.

With reference now to **Figure 3**, there is depicted a partial section view of a laminar power bus soldered to a substrate of a chip carrier in accordance with the method and system of the present invention. As illustrated, laminar power bus **26** includes insulating sheet **32** having conducting sheet **34** and **36** adhered to opposite sides thereof, and insulating sheets **52** and **54** adhered to the outer surfaces of conducting sheets **34** and **36**.

A depression in conducting sheet **34** forms dimple **38**, which protrudes through apertures **46**, **48**, and **50**, in insulating sheet **32**, conducting sheet **36**, and insulating sheet **52**, respectively. Similarly, a depression in conducting sheet **36** forms dimple **42**, which extends through aperture **50** in insulating sheet **52**. Although only one dimple **38** is shown in conducting sheet **34**, and one dimple **42** is shown in conducting sheet **36**, dimples **38** and **42** are among a plurality of such dimples which are not illustrated in **Figure 3**.

Dimples **38** and **42** include tips **56** and **58**, respectively, at a distal portion of the protrusion. As illustrated, tips **56** and **58** lie in substantially a single plane, thereby facilitating the bonding of dimples **38** and **42** to metal pads **40** and **44** on the surface of substrate **22**.

Solder **60** illustrates a typical means of bonding dimples **38** and **42** to metal pads **40** and **44**. To solder laminar power bus **26** to metal pads **40** and **44** of substrate **22**, a solder paste may be screened onto metal pads **40** and **44**. Thereafter, the protrusions of laminar power bus **26** are aligned and pressed into the solder paste which has been applied to the metal pads. Finally, laminar power bus **26** and chip carrier **16** are preferably placed in an infrared reflow soldering machine to complete the soldering process.

In order to prevent contact between conducting sheet **36** and conducting sheet **34**, apertures **48** and **50** in conducting sheet **36** and insulating sheet **52**, respectively, are preferably larger than aperture **46** in insulating sheet **32**. Thus, if dimple **38** were slightly malformed, causing it to bend closer to conductive sheet **36** at aperture **48**, the smaller aperture **46** makes it less likely that conductive sheets **34** and **36** would short together. In some designs, insulating sheets **52** and/or **54** are omitted altogether. If insulating sheet **52** or **54** is omitted, it is preferably to prevent conducting sheet **34** or **36** from contacting and shorting to other components or other conductive portions of the data processing system chassis.

To fabricate laminar power bus **26**, conducting and insulating sheets **32**, **34**, **36**, **52**, and **54** are preferably cut and formed individually, and then aligned and adhered to one another as illustrated in **Figures 2** and **3**. Conducting sheets **34** and **36** are preferably stamped between two die. Preferably, one of these two die has raised portions, while the other die has concave portions. These raised and concave portions of the die are aligned with one another. For conducting sheet **34**, such raised and concave portions in the two dire are arranged in a pattern corresponding to the positive terminal metal pads **40** (i.e., metal pads for connection to a higher voltage source) in the substrate **22** of a particular chip carrier **16**. For conducting sheet **36**, such raised and concave portions in the two die are arranged in a pattern corresponding to the negative terminal metal pads **44** (i.e., metal pads for connection to a lower voltage source) in the substrate **22** of a particular chip carrier **16**.

In a preferred method, the insulating sheets of laminar power bus **26** are formed using a stamping process and an appropriate die. Apertures **46**, **48**, and **50** are formed in a die stamping process. To prevent conducting sheet **34** from contacting conducting sheet **36**, apertures **48** and **50** are made larger than aperture **46**.

In order to prevent conducting sheets **34** and **36** from contacting other components within data processing system **10**, conducting sheets **34** and **36** are preferably recessed at the edges of laminar power bus **26** such that conducting sheets **34** and **36** are protected by insulating sheets **32**, **52**, and **54** extending beyond the outer edges of conducting sheets **34** and **36**.

Although there are many methods known in the art to connect laminar power bus **26** to power supply **12**, one typical method is to provide an aperture in both conducting sheet **34** and conducting sheet **36**, wherein the apertures are not overlapping, for receiving a screw or other fastener which physically and electrically connects each conducting sheet **34** and **36** to the appropriate terminal on power supply **12**. These apertures are appropriately free from insulating sheets **32**, **52**, and **54**, and adhesive to permit a low resistance electrical contact.

## Claims

1. A laminar power bus for providing electrical power to electronic devices enclosed in a chip carrier (16), said laminar power bus (26) characterized by comprising:
a plurality of interfacing sheets (32, 34, 36), each of substantially uniform thickness including:
(a) an insulating sheet (32) having first and second surfaces;
(b) a first conductive sheet (34) having an inner surface in contact with said first surface of said insulating sheet (32);
(c) a second conductive sheet (36) having an inner surface in contact with said second surface of said insulating sheet (32);
a first aperture (46) through said insulating sheet (32);
a second aperture (48) through said second conductive sheet (36) concentrically aligned with said first aperture (46) exposing said inner surface of said first conductive sheet (34);
a depression forming a first protrusion (38) in said first conductive sheet (34), said first protrusion (38) being concentrically aligned with said first and second apertures (46, 48) and extending through said first and second apertures (46, 48) beyond the plane of said second conductive sheet (36); and
a depression forming a second protrusion (42) in said second conductive layer (36) extending away from said insulating sheet (32).

2. The laminar power bus according to claim 1 wherein said first and second conductive sheets (34, 38) each respectively includes a plurality of said first protrusions (38) and a plurality of said second protrusions (42), wherein said insulating sheet (32) and said second conductive sheet each respectively includes a plurality of said first apertures (46) and a plurality of said second apertures (48) and wherein each protrusion of said pluralities of said first and second protrusions (38, 42) has a tip (56, 58) at a distal portion, and wherein each of said tips (56, 58) of said pluralities of said first and second protrusions (38, 42) lies in substantially a single plane.

3. The laminar power bus according to any preceding claim wherein said first and second conductive sheets (34, 36) are copper.

4. The laminar power bus according to any preceding claim wherein said insulating sheet (32) is an organic film.

5. The laminar power bus according to any preceding claim further including an insulating sheet (54) in contact with an outer surface of said first conductive sheet (34).

6. The laminar power bus according to any preceding claim further including:
an additional insulating sheet (52) in contact with an outer surface of said second conductive sheet (36); and
a plurality of third apertures (50) through said additional insulating sheet (52), wherein each third aperture is concentrically aligned with either one of said first protrusions (38) or said second protrusions (42), and wherein all of said first and second protrusions are exposed through said plurality of third apertures (50).

7. The laminar power bus according to any preceding claim further including connection means for connecting said laminar power bus (26) to a power supply (12), wherein said connection means includes:
an exposed area of said first conductive sheet (34) having an aperture therethrough for receiving a fastener for securing said first conductive sheet (34) in conductive contact (40) with a higher voltage terminal of said power supply (12); and
an exposed area of said second conductive sheet (36) having an aperture therethrough for receiving a fastener for securing said second conductive sheet (36) in conductive contact (44) with a lower voltage terminal of said power supply (12).

8. A method of fabricating a laminar power bus (26) for providing electrical power to electronic devices enclosed in a chip carrier (16), said chip carrier having a planar surface including a first set of metal pads (40), arranged in a first pattern, and a second set of metal pads (44), arranged in a second pattern, each of said metal pads (40, 44) for making an electrical connection, said method characterized by comprising the steps of:
stamping a plurality of first depressions forming a plurality of first protrusions (38) in a first conductive sheet (34) in a pattern corresponding to said first pattern;
stamping a plurality of second depressions forming a plurality of second protrusions (42) in a second conductive sheet (36) in a pattern corresponding to said second pattern;
stamping a plurality of first apertures (46) in an insulating sheet (32) in a pattern corresponding to said first pattern;
stamping a plurality of second apertures (48) in said second conductive sheet (36) in a pattern corresponding to said first pattern;
aligning said plurality of first protrusions (38) with said plurality of first apertures (46);
securing said first conductive sheet (34) to said insulating sheet (32) wherein said plurality of first protrusions (38) extend through said plurality of first apertures (46);
aligning said plurality of first protrusions (38) with said plurality of second apertures (48); and
securing said first conductive sheet (34) and said insulating sheet (32) to said second conductive sheet (36) wherein said plurality of first protrusions (38) extend through said plurality of second apertures (48).

9. The method of fabricating a laminar power bus according to claim 8 wherein each protrusion of said pluralities of said first and second protrusions (38, 42) in said first and second conductive sheets (34, 36) has a tip (56, 58) at a distal portion, and wherein each of said tips (56, 58) of said pluralities of said first and second protrusions (38, 42) lies in substantially a single plane.

10. The method of fabricating a laminar power bus according to claims 8 or 9 wherein said first and second conductive sheets (34, 36) are copper.

11. The method of fabricating a laminar power bus according to any claim 8 to 10 wherein said insulating sheet (32) is an organic film.

12. The method of fabricating a laminar power bus according to any claim 8 to 11 further including the step of securing a first outer insulating sheet (54) over said first conductive sheet (34).

13. The method of fabricating a laminar power bus according to any claim 8 to 12 further including the steps of:
stamping a plurality of third apertures (50) in a second outer insulating sheet (52) in a pattern corresponding to said first and second patterns;
aligning said pluralities of first and second protrusions (38, 42) in said first and second conductive sheets (34, 36) with said plurality of third apertures (50); and
securing said second outer insulating sheet (52) to said second conductive sheet (36) wherein said pluralities of first and second protrusions (38, 42) in said first and second conductive sheets (34, 36) extend through said plurality of third apertures (50).

14. The method of fabricating a laminar power bus according to any claim 8 to 13 further including the steps of:
providing an exposed area of said first conductive sheet (34) having an aperture therethrough for receiving a fastener for securing said first conductive sheet (34) in conductive contact (40) with a higher voltage terminal of said power supply (12); and
providing an exposed area of said second conductive sheet (36) having an aperture therethrough for receiving a fastener for securing said second conductive sheet (36) in conductive contact (44) with a lower voltage terminal of said power supply (12).

15. A method of distributing electrical power to an electronic device enclosed in a chip carrier (16), said chip carrier having a planar surface including a first set of metal pads (40) for connecting to a higher voltage source, and a second set of metal pads (44) for connecting to a lower voltage source, said first set of metal pads (40) being arranged in a first pattern, and said second set of metal pads (44) being arranged in a second pattern, said method comprising the steps of:
mounting said chip carrier (16) to a support structure wherein said first and second sets of metal pads (40, 44) are exposed;
providing a laminar power bus (26) comprising:
a plurality of interfacing sheets (32, 34, 36), each of substantially uniform thickness including:
(a) an insulating sheet (32) having first and second surfaces;
(b) a first conductive sheet (34) having an inner surface in contact with said first surface of said insulating sheet (32);
(c) a second conductive sheet (36) having an inner surface in contact with said second surface of said insulating sheet (32);
a plurality of first apertures (46) through said insulating sheet (32);
a plurality of second apertures (48) through said second conductive sheet (36) concentrically aligned with said plurality of first apertures (46) exposing said inner surface of said first conductive sheet (34);
a plurality of depressions forming a plurality of first protrusions (38) in said first conductive sheet (34), said plurality of first protrusions (38) being concentrically aligned with said pluralities of first and second apertures (46, 48) and said plurality of first protrusions (38) extending through said pluralities of first and second apertures (46, 48) beyond the plane of said second conductive sheet (36); and
a plurality of depressions forming a plurality of second protrusions (42) in said second conductive layer (36), each of said plurality of second protrusions (42) extending away from said insulating sheet (32);
aligning said plurality of first protrusions (38) with said first set of metal pads (40) and aligning said plurality of second protrusions (42) with said second set of metal pads (44);
bonding said plurality of first protrusions (38) with said first set of metal pads (40) and bonding said plurality of second protrusions (42) with said second set of metal pads (44);
connecting said first conductive sheet (34) to said higher voltage source; and connecting said second conductive sheet (36) to said lower voltage source.
